# EUROPÄISCHE PATENTSCHRIFT

(11) **EP 1 622 257 B1**
(45) Veröffentlichungstag und Bekanntmachung des Hinweises auf die Patenterteilung: **05.07.2006**
(21) Anmeldenummer: 05090179.2
(22) Anmeldetag: 17.06.2005
(51) Int. Cl.: H03F 3/08

(54) **Verstärkerschaltung zur Umwandlung des Stromsignals eines optischen Empfangselements in ein Spannungssignal**
Amplifier for converting a current signal of an optical receiving element into a voltage signal
Amplificateur pour convertir un signal de courant d'un récepteur optique en un signal de tension

(30) Priorität: 02.07.2004 US 585308 P; 25.02.2005 US 66944
(43) Veröffentlichungstag der Anmeldung: 01.02.2006
(73) Patentinhaber: Infineon Technologies Fiber Optics GmbH, 13629 Berlin (DE)
(72) Erfinder: Harms, Torsten, 01465 Langebrück (DE); van Waasen, Stefan, 19248 Sollentuna (SE)
(74) Vertreter: Müller, Wolfram Hubertus

(56) Entgegenhaltungen:
- DE-A1- 4 212 934
- US-A- 5 812 030
- US-A1- 2005 046 482
- US-B1- 6 307 433

## Beschreibung

Die Erfindung betrifft eine Verstärkerschaltung zur Umwandlung des Stromsignals eines optischen Empfangselements in ein Spannungssignal mit einem Transimpedanzverstärker. Insbesondere betrifft die Erfindung eine Verstärkerschaltung mit einem Transimpedanzverstärker, der einen hohen Dynamikbereich bei der Umwandlung eines Fotostroms in Spannungswerte bereitstellt.

### Hintergrund der Erfindung

Zum Empfang und zur Regenerierung von optischen Signalen nach Durchlaufen einer Übertragungsstrecke sind digitale optische Empfänger bekannt, die aus einer Empfängerschaltung, in der das optische Signal in ein analoges elektrisches Signal gewandelt wird, und einem digitalen Signalverarbeitungsteil, in dem das analoge Signal in ein digitales Datensignal mit normierter Amplitude und Taktinformation regeneriert wird, bestehen. In der Empfängerschaltung wird das empfangene optische Signal mittels einer Fotodiode in einen Fotostrom gewandelt und in einem Vorverstärker verstärkt.

Moderne optische Empfängerschaltungen müssen hohen Anforderungen bezüglich ihres Dynamikbereiches genügen. In der Regel werden zur Umwandlung des Fotostroms in Spannungswerte Strom-Spannungswanlder, sogenannte Transimpedanzverstärker (TIA) eingesetzt. Hierbei fließt der gesamte Fotostrom über einen Rückkopplungswiderstand und liegt am Ausgang des Transimpedanzverstärkers als Spannung an.

Um einen gewünschten Dynamikbereich von einigen 10 dB abzudecken, ist es bekannt, parallel zu dem Rückkopplungswiderstand einen MOS-Transistor zu schalten, der im Triodenbetrieb betrieben wird und dessen Gate-Spannung entsprechend der Höhe des Eingangssignals der Fotodiode und der Dynamikanforderung geregelt wird. Auf diese Weise wird ein linearer Widerstand parallel zum Rückkopplungswiderstand bereitgestellt. Da der resultierende Gesamtwiderstandswert aufgrund der Parallelschaltung zweier Widerstände sinkt, sinkt auch die Verstärkung des Transimpedanzverstärkers. Eine geringere Verstärkung geht einher mit einer reduzierten Stabilität bzw. Phasenreserve des Transimpedanzverstärkers und kann zu unerwünschten Oszillationen führen.

Es ist des Weiteren bekannt, zur Vermeidung solcher Oszillationen bzw. zur Aufrechterhaltung der Stabilität entweder die Leerlaufverstärkung zu reduzieren oder aber eine variable Kompensationskapazität parallel zum ohmschen Rückkopplungswiderstand und dem MOS-Transistor zu schalten. Die erste Alternative ist in der Regel nicht sinnvoll. Hinsichtlich der zweiten Alternative werden bei dem Stand der Technik bekannten Lösungen über mehrere Komparatoren und mehrere Referenzspannungen für diese Komparatoren stufenweise Kompensationskapazitäten hinzugeschaltet. Dies ist nachteilig mit einem hohen Schaltungsaufwand verbunden. Zudem ist das Regelverhalten diskontinuierlich.

Es besteht ein Bedarf nach einer Verstärkerschaltung zur Umwandlung des Stromsignals eines optischen Empfangselements in ein Spannungssignal mit einem Transimpedanzverstärker, die einen hohen Dynamikbereich bei gleichzeitiger Stabilität und kontinuierlichem Regelverhalten bereitstellt.

### Zusammenfassung der Erfindung

Die Erfindung stellt eine Verstärkerschaltung zur Umwandlung des Stromsignals eines optischen Empfangselements in ein Spannungssignal bereit, die folgende Merkmale aufweist: einen Transimpedanzverstärker mit einem Differenzverstärker und einen Rückkopplungswiderstand, einen dem Rückkopplungswiderstand parallel geschalteten ersten einstellbaren Widerstand, dessen Widerstandswert durch ein erstes Steuersignal festgelegt wird, und eine dem Rückkopplungswiderstand parallel geschaltete Serienschaltung einer ersten Kapazität und eines zweiten einstellbaren Widerstandes, dessen Widerstandswert durch ein zweites Steuersignal festgelegt wird.

Die vorliegende Erfindung beruht auf dem Gedanken, parallel zu einem schon vorhandenen einstellbaren Widerstand, der bevorzugt als MOS-Transistor ausgeführt ist, eine Serienschaltung einer Kapazität und eines weiteren einstellbaren Widerstands, der ebenfalls bevorzugt als MOS-Transistor ausgeführt ist, zu schalten. Die Serienschaltung einer Kapazität und eines Widerstands im Rückkopplungspfad des Differenzverstärkers wirkt als Pol-Nullstellen-Kompensation (lag-lead compensation). Der einstellbare Widerstand der Serienschaltung stellt dabei eine zusätzliche Phasendrehung bereit und verbessert die Phasenreserve des Transimpedanzverstärkers.

Es wird bevorzugt das schon vorhandene Steuersignal zur Einstellung des ersten einstellbaren Widerstandes dazu genutzt, um auch den zweiten einstellbaren Widerstand anzusteuern, der in Reihe mit der Kapazität geschaltet ist. Über die Dimensionierung der Kapazität und des zweiten einstellbaren Widerstandes ist über den gesamten Dynamikbereich die Stabilität der Schaltung gewährleistet. Bei Verwendung von MOS-Transistoren als einstellbaren Widerständen wird der zusätzliche Schaltungsaufwand sowie der Strom- und Flächenverbrauch minimal.

In einer bevorzugten Ausgestaltung ist vorgesehen, dass eine Vergleichseinrichtung mit zwei Eingängen und einem Ausgang vorhanden ist, wobei an dem einen Eingang ein Spannungssignal anliegt, das gleich dem Mittelwert des Signalhubs des am Ausgang des Transimpedanzverstärkers vorliegenden Signals ist. An dem anderen Eingang liegt ein Referenz-Spannungswert an. Der Ausgang der Vergleichseinrichtung stellt das Steuersignal für die einstellbaren Widerstände bereit.

Die Erfindung betrifft des weiteren eine optische Empfängerschaltung mit folgenden Komponenten: einer beleuchtbaren Photodiode, einer ersten Verstärkerschaltung zur Umwandlung des Ausgangssignals der beleuchtbaren Photodiode in ein Spannungssignal, einer unbeleuchtbaren Photodiode, die das elektrische Verhalten der beleuchtbaren Photodiode im beleuchtungsfreien Fall nachbildet, einer zweiten Verstärkerschaltung zur Umwandlung des Ausgangssignals der unbeleuchtbaren Photodiode in ein Spannungssignal, einem Nachverstärker mit einem ersten Eingang und einem zweiten Eingang, wobei dem ersten Eingang das Ausgangsignal der ersten Verstärkerschaltung und dem zweiten Eingang das Ausgangssignal der zweiten Verstärkerschaltung zugeführt wird, einer Regeleinrichtung zur Regelung des Ausgangssignals der zweiten Verstärkerschaltung auf den Mittelwert des Signalhubs des Ausgangssignals der ersten Verstärkerschaltung, und einer Vergleichseinrichtung mit zwei Eingängen und einem Ausgang, wobei an dem einen Eingang ein Spannungssignal anliegt, das gleich dem Mittelwert des Signalhubs des Ausgangssignals der ersten Verstärkerschaltung ist, und wobei an dem anderen Eingang ein Referenz-Spannungswert anliegt.

Dabei sind die Verstärkerschaltungen wie in Bezug auf den Anspruch 1 erläutert ausgestaltet. Somit weist die erste Verstärkerschaltung auf: einen ersten Transimpedanzverstärker mit einem ersten Differenzverstärker und einem ersten Rückkopplungswiderstand, einem dem ersten Rückkopplungswiderstand parallel geschalteten ersten einstellbaren Widerstand, dessen Widerstandswert durch ein Steuersignal festgelegt wird, und einer dem ersten Rückkopplungswiderstand parallel geschaltete Serienschaltung einer ersten Kapazität und eines zweiten einstellbaren Widerstandes, dessen Widerstandswert ebenfalls durch das Steuersignal festgelegt wird.

Die zweite Verstärkerschaltung weist auf: einen zweiten Transimpedanzverstärker mit einem zweiten Differenzverstärker und einem zweiten Rückkopplungswiderstand, einem dem zweiten Rückkopplungswiderstand parallel geschalteten dritten einstellbaren Widerstand, dessen Widerstandswert durch das Steuersignal festgelegt wird, und einer dem zweiten Rückkopplungswiderstand parallel geschaltete Serienschaltung einer zweiten Kapazität und eines vierten einstellbaren Widerstandes, dessen Widerstandswert ebenfalls durch das Steuersignal festgelegt wird. Dabei wird das Steuersignal für sämtliche einstellbaren Widerstände am Ausgang der Vergleichseinrichtung bereitgestellt.

### Beschreibung eines bevorzugten Ausführungsbeispiels

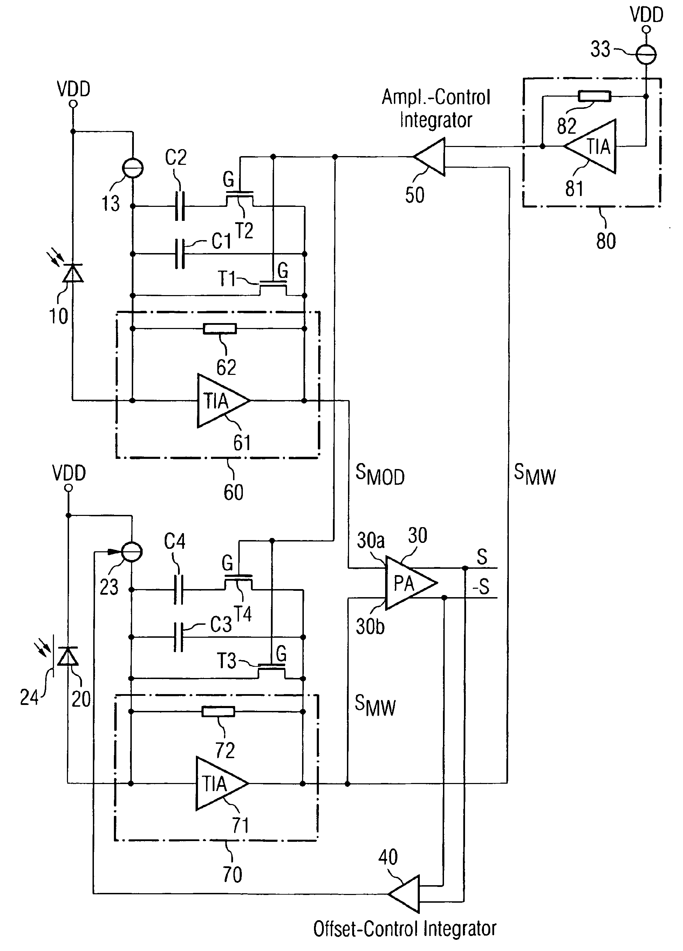

Die Erfindung wird nachfolgend unter Bezugnahme auf die Figuren anhand eines Ausführungsbeispiels näher erläutert. Die einzige Figur zeigt eine optische Empfängerschaltung zur Wandlung eines optischen Signals in ein analoges elektrisches Signal.

Die Figur beschreibt eine Schaltungsanordnung, bei der ein erstes optisches Empfangselement 10 in Form einer Photodiode vorgesehen, der ein optisches Informationssignal in ein elektrisches Signal umwandelt. Das elektrische Signal wird in einem Vorverstärker 60 verstärkt und dem einen Eingang 30a eines Nachverstärkers 30 (post amplifier) zugeführt, der ein Differenzverstärker ist. Bei dem Vorverstärker handelt es sich um einen Transimpedanzverstärker 60, der aus einem Spannungsverstärker 61 und einem Gegenkopplungswiderstand 62 besteht. Dem im Wesentlichen rechteckförmige Ausgangssignal der Photodiode 10 wird am Eingang des Transimpedanzverstärkers 60 ein konstanter Strom einer festen Stromquelle 13 überlagert, die einen geeigneten Offset am Eingang des Spannungsverstärkers 61 bereitstellt.

Parallel zum Gegenkopplungswiderstand 62 sind mehrere Schaltungselemente geschaltet. Ein erstes, parallel zum Gegenkopplungswiderstand 62 geschaltetes Schaltungselement ist ein Feldeffekttransistor T1. An dem Gate-Anschluss des Transistor T1 liegt ein von einer nachfolgend noch erläuterten Vergleichseinrichtung 50 bereitgestelltes Steuersignal an. Über dieses Steuersignal bzw. die Spannung am Gate-Anschluss wird ein bestimmter Widerstand des Transistors T1 bereitgestellt. Der Transistor T1 wird dabei bevorzugt im Triodenbereich betrieben, so dass eine lineare Abhängigkeit zwischen der anliegenden Spannung und dem Widerstand besteht.

Statt eines Feldeffekttransistors kann grundsätzlich auch ein bipolarer Transistor verwendet werden.

Durch das Bereitstellen eines parallel zum Gegenkopplungswiderstand 62 angeordneten weiteren Widerstandes T1 sinkt der Gesamtwiderstand im Rückkopplungskreis des Spannungsverstärkers 61. Dies führt dazu, dass die Verstärkung des Transimpedanzverstärkers 60 insgesamt sinkt.

Ein zweites Schaltungselement, das parallel zum Rückkopplungswiderstand 62 geschaltet ist, ist eine erste Kapazität C1. Diese Kapazität C1 stellt eine Kompensationskapazität dar, die der Vermeidung von Oszillationen bei einer sinkenden Verstärkung des Rückkopplungswiderstandes dient.

Drittens ist dem Rückkopplungswiderstand 62 die Reihenschaltung einer zweiten Kapazität C2 und eines zweiten Feldeffekttransistors T2 parallel geschaltet. Der Gate-Anschluss des zweiten Transistors T2 wird dabei mit der gleichen Steuerspannung beaufschlagt, mit der auch der Gate-Anschluss des ersten Transistor T1 beaufschlagt wird. Statt eines Feldeffekttransistors kann wiederum alternativ auch ein bipolarer Transistor verwendet werden. Die Feldeffekttransistoren T1, T2 sind bevorzugt als MOS-Transistoren ausgebildet.

Die dem Rückkopplungswiderstand 62 parallel geschaltete Serienschaltung der Elemente C2, T2 ermöglicht eine kontinuierliche Einstellung der Kompensationskapazität des Transimpedanzverstärkers, die durch die Kapazitäten C1, C2 gebildet wird. Dies wird mit einem geringen Schaltungsaufwand ermöglicht, da das Steuersignal für den Transistor T1 zur Steuerung der Spannung an dem Gate-Anschluss des mit der Kapazität C2 parallel geschalteten Transistors T1 benutzt wird. Die zur Sicherstellung der Stabilität notwendige Kompensationskapazität wird durch die weitere Kapazität C2 bereitgestellt, die über den steuerbaren Transistor T2 kontinuierlich einstellbar ist. Der einstellbare Widerstand T2 stellt dabei eine zusätzliche Phasendrehung bereit und verbessert die Phasenreserve des Transimpedanzverstärkers 60.

Ein im Wesentlichen identisches weiteres Schaltungsteil weist eine Fotodiode 20, einen Transimpedanzverstärker 70 mit einem Spannungsverstärker 71 und einem Gegenkopplungswiderstand 72, einen dritten Feldeffekttransistor T3, eine dritte Kapazität C3, und eine weitere Reihenschaltung einer vierten Kapazität C4 und eines vierten Feldeffekttransistors T4 auf. Die Gate-Anschlüsse der weiteren Transistoren T3, T4 werden dabei mit demselben Steuersignal beaufschlagt, mit dem auch die Gate-Anschlüsse der Transistoren T1 und T2 beaufschlagt werden.

Bei diesem Schaltungsteil ist die Photodiode 20 jedoch durch eine Blende 24 oder dergleichen abgedeckt. Es handelt sich um eine "Dummy-Photodiode", die das elektrische Verhalten der "sehenden" Photodiode 10 im beleuchtungsfreien Fall elektrisch nachbildet. Auf diese Weise können hochfrequente Störungen weitestgehend unterdrückt werden. Ein weiter Unterschied besteht darin, dass die Stromquelle 23 nicht wie die obere Stromquelle 13 konstant ist. Es handelt sich vielmehr um eine regelbare Stromquelle 13, die ein Regelsignal von einem Offset-Control-Integrator 40 erhält, wie noch erläutert werden wird.
Das Ausgangssignal S_{MOD} des oberen Transimpedanzverstärkers 60 und das Ausgangssignal S_{MW} des unteren Transimpedanzverstärkers 70 werden den beiden Eingängen 30a, 30b des Nachverstärkers 30 zugeführt. Da kein optisches Signal durch die Photodiode 20 detektiert wird, weist das an dem Eingang 30b anliegende Signal S_{MW} abgesehen von Störfrequenzen einen konstanten Wert auf. Das Signal S_{MOD} stellt dagegen das rechteckförmig modulierte Informationssignal dar.

Es ist anzustreben, zur Offset-Korrektur des von der Photodiode 10 abgegebenen und im Transimpedanzverstärker 60 verstärkten modulierten Signals S_{MOD} ein "Korrektursignal" S_{MW} in den unteren Eingang 30b des Nachverstärkers 30 einzuspeisen, dessen Größe genau 50 % des Signalhubs des Signals S_{MOD} am anderen Eingang 30a des Nachverstärkers 30 darstellt. Der Nachverstärker 30 stellt an seinem Ausgang ein Offset-korrigiertes, dem optischen Signal der Photodiode 10 entsprechendes Ausgangssignal S und ein dazu invertiertes Signal -S bereit.

Um zu erreichen, dass der Pegel S_{MW} am Ausgang des Transimpedanzverstärkers 21 gerade gleich dem Mittelwert des Signalhubs des Datenstromsignals S_{MOD} ist, erfolgt eine Regelung. Dies ist schematisch durch den Offset-Control-Integrator 40 dargestellt. In Abhängigkeit von dem differenziellen Ausgangssignal S, - S des Nachverstärkers 30 wird die Stromquelle 23 derart geregel, dass das am einen Eingang 30b des Nachverstärkers 30 anliegende Signal S_{MW} gerade bei 50% des Signalhubs des Nutzsignals liegt. Für diesen Fall werden am Ausgang des Nachverstärkers 30 zwei exakt zueinander inverse Signale S, -S erzeugt. Anderenfalls ist das Ausgangssignal verzerrt. Nachfolgende Komponenten werden differentiell angesteuert, d.h. die nachfolgenden Komponenten werten jeweils die Differenz zwischen zwei Eingangssignalen aus. Da die Signale invers zueinander sind, kann durch die nachfolgenden Komponenten eine doppelte Amplitude ausgewertet werden. Hierdurch wird die Störanfälligkeit reduziert und die Stabilität erhöht.

Die Empfängerschaltung weist eine Amplitudenregelung zur Einstellung der Amplitude des am Ausgang des Transimpedanzverstärkers 60 anliegenden Informationssignals S_{MOD} auf. Hierzu wird der konstante Ausgangswert im unteren Transimpedanzverstärkers 70, der bei 50 % des Signalhubs des Informationssignals S_{MOD} am Ausgang des oberen Transimpedanzverstärkers 60 liegt, in einer Vergleichseinrichtung 50 mit einem Referenzwert verglichen. Die Vergleichseinrichtung 50 ist beispielsweise als Integrator ausgebildet. Der Referenzwert wird über eine weitere Stromquelle 33 und einen weiteren Transimpedanzverstärker 80 mit Elementen 81, 82 bereitgestellt.

In Abhängigkeit von diesem Vergleich wird ein Spannungssignal bereitgestellt, das an den Gate-Anschlüssen der Transistoren T1, T2 des oberen Schaltungsteils und an den Gate-Anschlüssen der Transistoren T3, T4 des unteren Schaltungsteils anliegt. Über dieses Spannungs- bzw. Steuersignal wird zum einen mittels des Transistors T1 im oberen Schaltungsteil und mittels des Transistors T3 im unteren Schaltungsteil der Gesamt-Rückkopplungswiderstand und damit auch die Verstärkung des Transimpedanzverstärkers 60, 70 festgelegt. Bei einer niedrigen Verstärkung wird zum anderen durch die Serienschaltungen jeweils einer Kapazität C2, C4 und eines weiteren Transistors T2, T4 eine kontinuierliche Kompensation auftretender Oszillationen bereitgestellt.

Über das von der Vergleichseinrichtung 50 bereitgestellte Steuersignal kann somit der gewünschte Dynamikbereich der Empfängerschaltung eingestellt werden. Über die Dimensionierung der Kapazität C2, C4 und des jeweils weiteren Feldeffekttransistors T2, T4 in der Reihenschaltung kann über den gesamten Dynamikbereich die Stabilität der Verstärkung gewährleistet werden. Der zusätzliche Schaltungsaufwand sowie Strom- und Flächenverbrauch sind dabei minimal.

Es wird darauf hingewiesen, dass die erfindungsgemäße Schaltungseinrichtung mit Transimpedanzverstärker lediglich beispielhaft im Kontext der Empfängerschaltung der Figur beschrieben wurde. Sie kann auch in anders ausgebildeten Empfängerschaltungen eingesetzt werden.

Die Erfindung beschränkt sich in ihrer Ausgestaltung nicht auf die vorstehend dargestellten Ausführungsbeispiele. Der Fachmann erkennt, dass zahlreiche alternative Ausführungsvarianten existieren, die trotz ihrer Abweichung von den beschriebenen Ausführungsbeispielen von der in den nachfolgenden Ansprüchen definierten Lehre Gebrauch machen.

## Patentansprüche

1. Verstärkerschaltung zur Umwandlung des Stromsignals eines optischen Empfangselements in ein Spannungssignal, aufweisend:
- einen Transimpedanzverstärker (60; 70) mit:
o einem Differenzverstärker (61; 71) und
o einem Rückkopplungswiderstand (62; 72)
- einem dem Rückkopplungswiderstand (62; 72) parallel geschalteten ersten einstellbaren Widerstand (T1; T3), dessen Widerstandswert durch ein erstes Steuersignal festgelegt wird, und
- einer dem Rückkopplungswiderstand (62; 72) parallel geschaltete Serienschaltung einer ersten Kapazität (C2; C4) und eines zweiten einstellbaren Widerstandes (T2; T4), dessen Widerstandswert durch ein zweites Steuersignal festgelegt wird.

2. Schaltung nach Anspruch 1, wobei der erste einstellbare Widerstand (T1; T3) ein erster Feldeffekttransistor ist, an dessen Gate-Anschluss das erste Steuersignal anliegt.

3. Schaltung nach Anspruch 2, wobei der erste Feldeffekttransistor (T1; T3) im Triodenbereich betrieben wird.

4. Schaltung nach Anspruch 1, wobei der zweite einstellbare Widerstand (T2; T4) ein zweiter Feldeffekttransistor ist, an dessen Gate-Anschluss das zweite Steuersignal anliegt.

5. Schaltung nach Anspruch 4, wobei der zweite Feldeffekttransistor (T2; T4) im Triodenbereich betrieben wird.

6. Schaltung nach Anspruch 1, wobei des weiteren eine zweite Kapazität (C1; C3) vorgesehen ist, die dem Rückkopplungswiderstand (62; 72) ebenfalls parallel geschaltet ist.

7. Schaltung nach Anspruch 1, wobei das erste Steuersignal und das zweite Steuersignal identisch sind und von der gleichen Quelle stammen.

8. Schaltung nach Anspruch 7, wobei
- des weiteren eine Vergleichseinrichtung (50) mit zwei Eingängen und einem Ausgang vorhanden ist,
- an dem einen Eingang ein Spannungssignal anliegt, das gleich dem Mittelwert des Signalhubs des am Ausgang des Transimpedanzverstärkers vorliegenden Signals ist,
- an dem anderen Eingang ein Referenz-Spannungswert anliegt, und
- deren Ausgang das Steuersignal bereitstellt wird.

9. Optische Empfängerschaltung mit
- einer beleuchtbaren Photodiode (10);
- einer ersten Verstärkerschaltung (60) zur Umwandlung des Ausgangssignals der beleuchtbaren Photodiode in ein Spannungssignal;
- einer unbeleuchtbaren Photodiode (20), die das elektrische Verhalten der beleuchtbaren Photodiode (10) im beleuchtungsfreien Fall nachbildet;
- einer zweiten Verstärkerschaltung (70) zur Umwandlung des Ausgangssignals der unbeleuchtbaren Photodiode in ein Spannungssignal;
- einem Nachverstärker (30) mit einem ersten Eingang (30a) und einem zweiten Eingang (30b), wobei dem ersten Eingang das Ausgangsignal der ersten Verstärkerschaltung (60) und dem zweiten Eingang das Ausgangssignal der zweiten Verstärkerschaltung (70) zugeführt wird,
- einer Regeleinrichtung (40) zur Regelung des Ausgangssignals der zweiten Verstärkerschaltung auf den Mittelwert des Signalhubs des Ausgangssignals der ersten Verstärkerschaltung, wobei das Ausgangssignal des Nachverstärkers (30) der Regeleinrichtung (40) als Regelgröße zugeführt wird, und mit einer
- einer Vergleichseinrichtung (50) mit zwei Eingängen und einem Ausgang, wobei an dem einen Eingang ein Spannungssignal anliegt, das gleich dem Mittelwert des Signalhubs des Ausgangssignals der ersten Verstärkerschaltung ist und an dem anderen Eingang ein Referenz-Spannungswert anliegt,
- wobei die erste Verstärkerschaltung aufweist:
o einen ersten Transimpedanzverstärker (60) mit:
■ einem ersten Differenzverstärker (61), und
■ einem ersten Rückkopplungswiderstand (62),
o einem dem ersten Rückkopplungswiderstand (62) parallel geschalteten ersten einstellbaren Widerstand (T1), dessen Widerstandswert durch ein Steuersignal festgelegt wird, und
o einer dem ersten Rückkopplungswiderstand (62) parallel geschaltete Serienschaltung einer ersten Kapazität (C2) und eines zweiten einstellbaren Widerstandes (T2), dessen Widerstandswert ebenfalls durch das Steuersignal festgelegt wird,
- wobei die zweite Verstärkerschaltung aufweist:
o einen zweiten Transimpedanzverstärker (70) mit:
■ einem zweiten Differenzverstärker (71), und
■ einem zweiten Rückkopplungswiderstand (72),
o einem dem zweiten Rückkopplungswiderstand (72) parallel geschalteten dritten einstellbaren Widerstand (T3), dessen Widerstandswert durch das Steuersignal festgelegt wird, und
o einer dem zweiten Rückkopplungswiderstand (72) parallel geschaltete Serienschaltung einer zweiten Kapazität (C4) und eines vierten einstellbaren Widerstandes (T4), dessen Widerstandswert ebenfalls durch das Steuersignal festgelegt wird, und
- wobei das Steuersignal für die einstellbaren Widerstände am Ausgang der Vergleichseinrichtung (50) bereitgestellt wird.

10. Empfängerschaltung nach Anspruch 9, wobei der erste einstellbare Widerstand (T1), der zweite einstellbare Widerstand (T2), der dritte einstellbare Widerstand (T3) und der vierte einstellbare Widerstand (T4) jeweils als Feldeffekttransistor ausgeführt sind.

11. Empfängerschaltung nach Anspruch 10, wobei die Feldeffekttransistoren jeweils im Triodenbereich betrieben werden.

12. Empfängerschaltung nach Anspruch 9, wobei die erste Verstärkerschaltung (60) und die zweite Verstärkerschaltung (70) zusätzlich jeweils eine weitere Kapazität (C1; C3) aufweisen, die dem Rückkopplungswiderstand (62; 72) parallel geschaltet ist.

13. Empfängerschaltung nach Anspruch 9, wobei der Referenz-Spannungswert an dem einen Eingang der Vergleichseinrichtung (50) durch einen weiteren Transimpedanz-Verstärker (80) bereitgestellt wird.

## Claims

1. An amplifier circuit for converting the current signal from an optical receiving element into a voltage signal, comprising:
- a transimpedance amplifier (60; 70) comprising:
o a differential amplifier (61; 71), and
o a feedback resistor (62; 72),
- a first adjustable resistor (T1; T3) which is connected in parallel with the feedback resistor (62; 72) and whose resistance value is defined by a first control signal, and
- a series circuit connected in parallel with the feedback resistance (62; 72), comprising a first capacity (C2; C4) and a second adjustable resistor (T2; T4), whose resistance value is defined by a second control signal.

2. The circuit as claimed in claim 1, wherein the first adjustable resistor (T1; T3) is a first field effect transistor, to whose gate terminal the first control signal is applied.

3. The circuit as claimed in claim 2, wherein the first field effect transistor (T1; T3) is operated in the triode range.

4. The circuit as claimed in claim 1, wherein the second adjustable resistor (T2; T4) is a second field effect transistor, to whose gate terminal the second control signal is applied.

5. The circuit as claimed in claim 4, the second field effect transistor (T2; T4) being operated in the triode range.

6. The circuit as claimed in claim 1, a second capacity (C1; C3) also being provided, which is likewise connected in parallel with the feedback resistor (62; 72).

7. The circuit as claimed in claim 1, wherein the first control signal and the second control signal are identical and originate from the same source.

8. The circuit as claimed in claim 7, wherein
- there is also a comparison device (50) having two inputs and one output,
- to the one input a voltage signal is applied which is equal to the average of the signal range of the signal present at the output of the transimpedance amplifier,
- a reference voltage value being applied to the other input, and
- at whose output the control signal is provided.

9. An optical receiver circuit comprising
- a photodiode (10) which can be illuminated;
- a first amplifier circuit (60) for converting the output signal from the photodiode that can be illuminated into a voltage signal;
- a photodiode (20) which cannot be illuminated, which simulates the electrical behavior of the photodiode (10) that can be illuminated when it is free of illumination;
- a second amplifier circuit (70) for converting the output signal from the photodiode that cannot be illuminated into a voltage signal;
- a post-amplifier (30) having a first input (30a) and a second input (30b), the output signal from the first amplifier circuit (60) being supplied to the first input and the output signal from the second amplifier circuit (70) being supplied to the second input;
- a control device (40) for regulating the output signal from the second amplifier circuit to the average of the signal range of the output signal from the first amplifier circuit, the output signal from the post-amplifier (30) being supplied to the control device (40) as a controlled variable, and comprising
- a comparison device (50) having two inputs and one output, a voltage signal being applied to one input which is equal to the average of the signal range of the output signal from the first amplifier circuit, and a reference voltage value being applied to the other input,
- the first amplifier circuit comprising:
o a first transimpedance amplifier (60) comprising:
■ a first differential amplifier (61), and
■ a feedback resistor (62),
o a first adjustable resistor (T1) which is connected in parallel with the first feedback resistor (62) and whose resistance value is defined by a control signal, and
o a series circuit connected in parallel with the first feedback resistor (62), comprising a first capacity (C2) and a second adjustable resistor (T2), whose resistance value is likewise defined by the control signal,
- the second amplifier circuit comprising:
o a second transimpedance amplifier (70) comprising:
■ a second differential amplifier (71), and
■ a second feedback resistor (72),
o a third adjustable resistor (T3) which is connected in parallel with the second feedback resistor (72) and whose resistance value is defined by the control signal, and
o a series circuit connected in parallel with the second feedback resistor (72), comprising a second capacity (C4) and a fourth adjustable resistor (T4), whose resistance value is likewise defined by the control signal, and
- the control signal for the adjustable resistors being provided at the output of the comparison device (50).

10. The receiver circuit as claimed in claim 9, wherein the first adjustable resistor (T1), the second adjustable resistor (T2), the third adjustable resistor (T3) and the fourth adjustable resistor (T4) are in each case formed as a field effect transistor.

11. The receiver circuit as claimed in claim 10, wherein the field effect transistors are each operated in the triode range.

12. The receiver circuit as claimed in claim 9, wherein the first amplifier circuit (60) and the second amplifier circuit (70) additionally have a further capacity (C1; C3) in each case, which is connected in parallel with the feedback resistor (62; 72).

13. The receiver circuit as claimed in claim 9, wherein the reference voltage value at the one input of the comparison device (50) is provided by a further transimpedance amplifier (80).

## Revendications

1. Circuit amplificateur pour transformer le signal de courant d'un récepteur optique en un signal de tension comprenant :
- un amplificateur (60, 70) de transimpédance ayant :
o un amplificateur (61, 71) différentiel ; et
o une résistance (62, 72) de réaction
- une première résistance (T1, T3) réglable qui est montée en parallèle avec la résistance (62, 72) de réaction et dont la valeur est fixée par un premier signal de commande, et
- un circuit série, monté en parallèle avec la résistance (62, 72) de réaction et constitué d'une première capacité (C2, C4) et d'une deuxième résistance (T2, T4) dont la valeur est fixée par un deuxième signal de commande.

2. Circuit suivant la revendication 1, dans lequel la première résistance (T1, T3) réglable est un premier transistor à effet de champ à la borne de grille duquel s'applique le premier signal de commande.

3. Circuit suivant la revendication 2, dans lequel le premier transistor (T1, T3) à effet de champ fonctionne dans le domaine triode.

4. Circuit suivant la revendication 1, dans lequel la deuxième résistance (T2, T4) réglable est un deuxième transistor à effet de champ à la borne de grille duquel s'applique le deuxième signal de commande.

5. Circuit suivant la revendication 4, dans lequel le deuxième transistor (T2, T4) à effet de champ fonctionne dans le domaine triode.

6. Circuit suivant la revendication 1, dans lequel il est prévu, en outre, une deuxième capacité (C1, C3) qui est montée également en parallèle avec la résistance (62, 72) de réaction.

7. Circuit suivant la revendication 1, dans lequel le premier signal de commande et le deuxième signal de commande sont identiques et proviennent de la même source.

8. Circuit suivant la revendication 7, dans lequel
- il y a, en outre, un dispositif (5) de comparaison ayant deux entrées et une sortie ;
- il s'applique à l'une des entrées un signal de tension qui est égal à la valeur moyenne de l'excursion du signal présent à la sortie de l'amplificateur de transimpédance ;
- il s'applique à l'autre entrée une autre valeur de tension de référence ; et
- le signal de commande est mis à disposition à sa sortie.

9. Récepteur optique comprenant :
- une photodiode (10) pouvant être éclairée ;
- un premier circuit (60) amplificateur pour transformer le signal de sortie de la photodiode qui peut être éclairée en un signal de tension ;
- une photodiode (20) qui ne peut pas être éclairée et qui reproduit dans le cas d'une absence d'éclairage le comportement électrique de la photodiode (10) pouvant être éclairée ;
- un deuxième circuit (70) amplificateur pour transformer le signal de sortie de la photodiode qui ne peut pas être éclairée en un signal de tension ;
- un post-amplificateur (30) ayant une première entrée (30a) et une deuxième entrée (30b), le signal de sortie du premier circuit (60) amplificateur étant envoyé à la première entrée et le signal de sortie du deuxième circuit (70) amplificateur étant envoyé à la deuxième entrée ;
- un dispositif (40) de régulation du signal de sortie du deuxième circuit amplificateur sur la valeur moyenne de l'excursion du signal de sortie du premier circuit amplificateur, le signal de sortie du post-amplificateur (30) étant envoyé au dispositif (40) de régulation en tant que grandeur de régulation, et comprenant
- un dispositif (50) de comparaison ayant deux entrées et une sortie dans lequel il s'applique à l'une des entrées un signal de tension qui est égal à la valeur moyenne de l'excursion du signal de sortie du premier circuit amplificateur et il s'applique à l'autre entrée une valeur de tension de référence ;
- dans lequel le premier circuit amplificateur a :
o un premier amplificateur (60) de transimpédance ayant :
• un premier amplificateur (61) différentiel ; et
• une première résistance (62) de réaction,
o une première résistance (T1) réglable qui est montée en parallèle avec la première résistance (62) de réaction et dont la valeur est fixée par un signal de commande ; et
o un circuit série, monté en parallèle à la première résistance (62) de réaction et constitué d'une première capacité (C2) et d'une deuxième résistance (T2) réglable dont la valeur est fixée également par le signal de commande ;
- le deuxième circuit amplificateur comprenant :
o un deuxième amplificateur (70) de transimpédance ayant :
• un deuxième amplificateur (71) différentiel ; et
• une deuxième résistance (72) de réaction,
o une troisième résistance (T3) réglable qui est montée en parallèle avec la deuxième résistance (72) de réaction et dont la valeur de résistance est fixée par le signal de commande ; et
o un deuxième circuit série, monté en parallèle avec la deuxième résistance (72) de réaction et constitué d'une deuxième capacité (C4) et d'une quatrième résistance (T4) réglable dont la valeur est fixée également par le signal de commande ; et
- dans lequel le signal de commande des résistances réglables est mis à disposition à la sortie du dispositif (50) de comparaison.

10. Récepteur optique suivant la revendication 9, dans lequel la première résistance (T1) réglable, la deuxième résistance (T2) réglable, la troisième résistance (T3) réglable et la quatrième résistance (T4) réglable sont réalisées, respectivement, sous la forme de transistors à effet de champ.

11. Récepteur optique suivant la revendication 10, dans lequel les transistors à effet de champ fonctionnent, respectivement, dans le domaine triode.

12. Récepteur optique suivant la revendication 9, dans lequel le premier circuit (60) amplificateur et le deuxième circuit (70) amplificateur ont, en outre, respectivement, une capacité (C1, C3) supplémentaire qui est montée en parallèle avec la résistance (62, 72) de réaction.

13. Récepteur optique suivant la revendication 9, dans lequel la valeur de tension de référence est mise à disposition sur l'une des entrées du dispositif (50) de comparaison par un autre amplificateur (80) de transimpédance.
